# EUROPEAN PATENT APPLICATION

(11) **EP 3 135 479 A1**
(43) Date of publication of application: **01.03.2017**
(21) Application number: 15783657.8
(22) Date of filing: 23.04.2015
(51) Int. Cl.: B32B 9/00, B05D 3/02, B32B 27/30, B65D 65/40

(54) **GAS BARRIER MULTILAYER FILM AND METHOD FOR PRODUCING SAME**

(30) Priority: 25.04.2014 JP 2014092050
(71) Applicant: Toppan Printing Co., Ltd., Tokyo 110-0016 (JP)
(72) Inventor: TAKEUCHI Iori, Tokyo 110-0016 (JP); KASHIMURA Masayuki, Tokyo 110-0016 (JP); MATSUI Miyu, Tokyo 110-0016 (JP)
(74) Representative: Hoffmann Eitle
(86) International application number: PCT/JP2015/062384
(87) International publication number: WO 2015/163413

(57) **Abstract**

A gas barrier multilayer film includes a film substrate, a layer formed on at least one surface of the film substrate and made of an inorganic compound, and a gas barrier layer formed on the layer made of the inorganic compound and formed of a mixture, which contains an acrylic acid polymer made of poly(meth)acrylic acid or a partially neutralized product thereof wherein a degree of neutralization of the poly(meth)acrylic acid with zinc is not larger than 25 mol%, a sugar or starch, and a hypophosphite wherein the hypophosphite is present at 1 mass% to 15 mass% of a total solid content of the mixture.

## Description

### Technical Field

This invention relates to a gas barrier multilayer film used in the packaging field of vacuum heat insulation materials, life-related materials (for foods and medical products) and the like, and also to a method for manufacturing the same.

This application claims the benefits of priority based on Japanese Patent Application No. 2014-092050, filed on April 25, 2014, the content which is incorporated herein by reference.

### Background Art

The packaging materials in the fields of industries and foods are required to have the capability to prevent the degradation of content quality. Especially, with a packaging material for vacuum heat insulation materials employed in refrigerators or low temperature containers, it should have excellent gas barrier properties so as to prevent outside gases from entering and maintain a vacuum therein over a long term.

In order to impart high gas barrier properties to a packaging material, the usual practice is to make main use of laminate films including a metallic aluminum foil having a thickness of about 7 µm to 15 µm as a gas barrier layer of the packaging material.

However, although such a metallic aluminum foil has excellent gas barrier properties, there has been a problem that aluminum has high thermal conductivity, so that adequate heat insulation properties are not obtained due to the thermal conductivity through the packaging material. To solve this problem, there has been proposed a packaging material made of a vacuum heat insulation material making use of an aluminum-deposited ethylene-vinyl alcohol copolymer (EVOH) as a gas barrier layer (see, for example, PTL 1). However, the EVOH used to form the gas barrier layer is hygroscopic in nature, so that with the case of the long-term storage under high temperature and high humidity, the gas barrier properties of the packaging material are lowered, with some concern that good heat insulation performance cannot be ensured. Hence, although a packaging material configured to have a hygroscopic layer has been proposed, the hygroscopic performance is not good even with such a packaging material including the hygroscopic layer, with the possibility that the gas barrier properties are lowered (see, for example, PTL 2). In either case, when the packaging material is processed as a vacuum heat insulation material, cracks or pinholes are formed in the aluminum deposited layer to lower barrier properties, thus making it impossible to keep a vacuum inside the packaging material over a long time.

### Citation List

### Patent Literature

PTL 1: JP-A-2007-327619
PTL 2: JP-B-5407888

### SUMMARY OF INVENTION

### Technical Problem

The present invention has been made under such circumstances as stated above and has for its object the provision of a gas barrier multilayer film having excellent gas barrier properties, which has gas barrier properties not lowered by moisture absorption and in which its gas barrier layer is excellent in maltreatment resistance and is less likely to be degraded after having been subjected to flexing or stretching and also of method for manufacturing the same.

### Solution to Problem

A gas barrier multilayer film according to a first embodiment of the invention includes a film substrate, a layer formed on at least one surface of the film substrate and made of an inorganic compound, and a gas barrier layer formed on the layer made of the inorganic compound and formed of a mixture, which contains an acrylic acid polymer made of poly(meth)acrylic acid or a partially neutralized product thereof wherein a degree of neutralization of poly(meth)acrylic acid with zinc is not larger than 25 mol%, a sugar or starch, and a hypophosphite wherein the hypophosphite is present at 1 mass% to 15 mass% of the total solid content of the mixture.

The layer made of the inorganic compound is formed by a vacuum deposition process and can be made of at least one member selected from the group consisting of aluminum, aluminum oxide, magnesium oxide and silicon oxide.

A method for manufacturing a gas barrier multilayer film according to a second embodiment of the invention includes forming a gas barrier layer on a layer which is formed on at least one surface of a film substrate and made of an inorganic compound, wherein when the gas barrier layer is formed, a coating solution, which is comprised of a mixture of an acrylic acid polymer made of poly(meth)acrylic acid or a partially neutralized product thereof wherein a degree of neutralization of a poly(meth)acrylic acid with zinc is not larger than 25 mol%, a sugar or starch, and a hypophosphite, is coated and thermally treated at a temperature of from 150°C to 250°C, inclusive, for 300 seconds or below.

### Effect of Invention

According to the first and second embodiments of the invention, there can be provided a gas barrier multilayer film wherein gas barrier properties are not lowered by moisture absorption, and its gas barrier layer is excellent in maltreatment resistance and is less likely to be degraded after having been subjected to flexing or stretching, and which has thus excellent gas barrier properties.

### Brief Description of Drawing

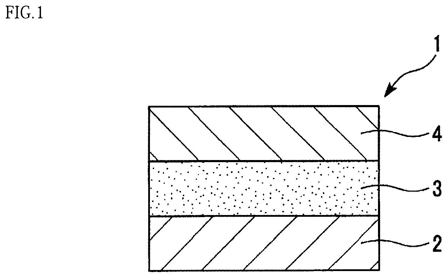

[Fig. 1] is a sectional view showing an example of gas barrier multilayer film according to an embodiment of the invention.

### Description of Embodiments

The gas barrier multilayer film and its manufacturing method according to the embodiments of the invention are now described.

It will be noted that these embodiments are particularly described for better understanding of the concept of the invention and should not be construed as limiting the invention thereto unless otherwise specified.

### [Gas barrier multilayer film 1]

A gas barrier multilayer film 1 related to a first embodiment of the invention includes a film substrate 2, a layer 3 formed on at least one surface of the film substrate 2 and made of an inorganic compound, and a gas barrier layer 4 formed on the layer 3 made of the inorganic compound and made of a mixture, which contains an acrylic acid polymer made of poly(meth)acrylic acid or a partially neutralized product thereof wherein a degree of neutralization of poly(meth)acrylic acid with zinc is not larger than 25 mol%, a sugar or starch, and a hypophosphite, wherein the hypophosphite is present at 1 mass% to 15 mass%, inclusive, relative to a total solid content of the mixture.

### [Film substrate 2]

The film substrate 2 includes, for example, a polyester film such as of polyethylene terephthalate (PET), polyethylene naphthalate (PEN) or the like, a polyolefin film such as of polyethylene, polypropylene or the like, a polystyrene film, a polyamide film such as of 66-nylon, a polycarbonate film, or an engineering plastic film such as a polycarbonate, film, a polyacrylonitrile film, a polyimide film or the like. The resin materials therefor may be either stretched ones or unstretched ones, and those resin materials having mechanical strength and dimensional stability are preferred. The resin material is used as a substrate after processed into film. Of these films, the films optionally stretched in biaxial directions are preferably used. Moreover, when consideration is taken for cost, moisture-proofing property, filling adaptability, texture and disposability on use as a packaging material, a polyamide film and a polyester film are preferred, of which the polyester film is more preferred.

Although not specifically limited, the thickness of the film sbstrate 2 in practical applications is preferably from 3 µm to 200 µm, more preferably from 6 µm to 30 µm when consideration is taken for adaptability as a packaging material and processability.

The surface of the film substrate 2 may be applied, if necessary, with a variety of known additives and stabilizers including, for example, an antistatic agent, a plasticizer, a lubricant, an antioxidant and the like.

This type of film substrate 2 may be subjected to surface activation treatment such as a corona treatment, a flame treatment, a plasma treatment or the like from the standpoint of the adhesion between the film substrate 2 an adhesive layer.

### [Inorganic compound]

The layer 3 made of an inorganic compound (inorganic compound layer) is constituted of an inorganic compound or an inorganic oxide.

The inorganic compound or inorganic oxide are appropriately selected from those inorganic compounds or inorganic oxides capable of forming the inorganic compound layer 3 that is provided to impart gas barrier properties to the gas barrier multilayer film 1 of the present embodiment. Examples of the inorganic compound or inorganic oxide include aluminum, aluminum oxide, magnesium oxide, silicon oxide, tin oxide and the like. As an inorganic compound or inorganic oxide, at least one member selected from the group consisting of aluminum, aluminum oxide, magnesium oxide and silicon oxide is preferred in view of high gas barrier properties thereof. The inorganic compounds or inorganic oxides may be used singly or in combination of two or more, if necessary.

The thickness of the inorganic compound layer 3 differs, more or less, depending on the purpose in use of the gas barrier multilayer film 1 of the embodiment and also on the thickness of a gas barrier coating layer. The thickness is preferably from 5 nm to 300 nm, more preferably from 10 nm to 50 nm.

If the thickness of the inorganic compound layer 3 is less than 5 nm, there may be some concern that the continuity of the inorganic compound layer 3 is lost. On the other hand, when the thickness of the inorganic compound layer 3 exceeds 300 nm, the flex (flexibility) of the inorganic compound layer 3 lowers, with concern that after formation of the inorganic compound layer 3, the inorganic compound layer 3 suffers cracks due to external factors such as of flexing and pulling of a packaging material.

For the formation of the inorganic compound layer 3, various methods may be used including, for example, an ordinary vacuum deposition method, and other thin film forming methods such as a sputtering method, an ion plating method, a chemical vapor deposition method and the like.

A preferred heating method of a vacuum deposition apparatus using the vacuum deposition method includes an electron beam heating method, a resistance heating method, an induction heating method or the like. In order to improve the adhesion of the inorganic compound layer 3 to the film substrate 2 and the denseness of the inorganic compound layer 3, a plasma-assisted method or an ion beam-assisted method may also be used in addition to the above-indicated heating methods.

To increase the transparency of the inorganic compound layer 3, reactive deposition by blowing an oxygen gas may be feasible.

Aluminum oxide is preferably one wherein the existing ratio between aluminum (Al) and oxygen (O) is such that Al:O = 1:1.5 to 1:2.0 in terms of molar ratio. For instance, the aluminum oxide deposition layer can be formed by providing aluminum as a deposition material and subjecting it to reactive deposition, reactive sputtering, reactive ion plating or the like wherein thin film formation is carried out in the presence of a mixed gas of oxygen and an inert gas such as carbon dioxide. On this occasion, when aluminum is reacted with oxygen, Al₂O₃ has to be stoichiometrically formed, for which the existing ratio between aluminum (Al) and oxygen (O) should be at Al:O = 1:1.5 in terms of molar ratio. However, there are chemical species wherein aluminum partially remains as it is, and other types of chemical species existing in the form of aluminum peroxide although depending on the manner of vacuum deposition. When the existing ratios of elements in an aluminum oxide deposition layer are measured such as by an X-ray photoelectron spectrometer (XPS), it will be seen that the existing ratio of aluminum (Al) and oxygen (O) is not necessarily such that Al:O = 1:1.5 in terms of molar ratio. In general, where the existing ratio of aluminum (Al) and oxygen (O) in terms of molar ratio is such that an amount of oxygen is smaller and an amount of aluminum is larger than with the case of Al:O = 1:1.5, the aluminum oxide deposition layer becomes dense (or the density of the aluminum oxide deposition layer becomes high), so that although good barrier properties are obtained, the resulting aluminum oxide deposition layer tends to be colored black and to lower in the quantity of light transmission. On the other hand, where the existing ratio of aluminum (Al) and oxygen (O) in terms of molar ratio is such that an amount of oxygen is larger and an amount of aluminum is smaller than with the case of Al:O = 1:1.5, the aluminum oxide deposition layer becomes coarse (or the density of the aluminum oxide deposition layer becomes low), the gas barrier properties are worsened and the quantity of light transmission becomes high, ensuring transparency.

Silicon oxide is favorably used especially when the inorganic compound layer 3 should have waterproofness.

### [Anchor coat layer]

The inorganic compound layer 3 may be formed on one surface of the film substrate 2 through an anchor coat layer so as to enhance adhesion to the film substrate 2.

The constituent materials of the anchor coat layer include, for example, a urethane resin, an epoxy resin, an acrylic acid resin, a polyester resin and the like.

Although depending on the intended purpose, additives such as a curing gent, a silane coupling agent and the like may be added to the constituent material of the anchor coat layer. Especially, the use of a combination of an acrylic polyol, an isocyanate compound, and a silane coupling agent is preferred as the additive. When the anchor coat layer having such a formulation as indicated above is formed, stable, high adhesion between the film substrate 2 and the inorganic compound layer 3 is obtained.

The thickness of the anchor layer is not specifically limited so far as a uniform coating layer is formed on one surface of the film substrate 2 and is preferably from 0.01 µm to 2 µm, more preferably from 0.05 µm to 0.5 µm.

If the thickness of the anchor coat layer is less than 0.01 µm, it is unlikely to obtain a uniform coating layer (anchor coat layer), with some cases that adhesion of the inorganic compound layer 3 to the film substrate 2 is lowered. On the other hand, when the thickness of the anchor coat layer exceeds 2 µm, the flex (flexibility) of the anchor coat layer is impaired, with concern that the anchor coat layer may be unfavorably cracked by an external factor.

If the thickness of the anchor layer ranges from 0.05 µm to 0.5 µm, industrial production becomes easy thereby ensuring good barrier properties with the aid of the anchor coat layer.

### [Acrylic acid polymer]

The acrylic acid polymer is preferably one that has a degree of polymerization of 20 to 20,000. The degree of polymerization is more preferably from 50 to 10,000 from the standpoint of the waterproofing property of the gas barrier multilayer film 1.

If the degree of polymerization of the acrylic acid polymer is less than 20, not only adequate waterproofing properties cannot be imparted to the gas barrier multilayer film 1, but also there is some concern that gas barrier properties and transparency may be worsened by moisture, or whitening may occur. On the other hand, when the degree of polymerization of the acrylic acid polymer exceeds 20,000, there are some cases where viscosity becomes high and thus, coating properties may be impaired.

The acrylic acid polymer may contain a zinc compound.

When part of the carboxyl groups in the acrylic acid polymer has been neutralized with zinc beforehand, the waterproofing properties of the acrylic acid polymer can be improved. The degree of neutralization of the carboxyl group with zinc is preferably not larger than 30 mol%, more preferably not larger than 25 mol%, from the standpoint of the stability of a coating solution containing the acrylic acid polymer (i.e. a coating solution used for forming the gas barrier layer 4).

The zinc compound includes, for example, elemental zinc, an oxide, a hydroxide, a carbonate, an organic acid salt (e.g. an acetate salt), an inorganic acid salt, or an ammonium complex, secondary to quaternary amine complexes or a carbonate or an organic acid salt thereof. Of these zinc compounds, zinc oxide and zinc acetate are preferred in view of the industrial productivity thereof, and zinc oxide is more preferred.

### [Sugars or starches]

As to sugars or starches, usable sugars (which may also be called carbohydrates) include monosaccharides, oligosaccharides and polysaccharides. These sugars embrace sugar alcohols, a variety of substitution products and derivatives. Preferred sugars are those sugars soluble in water.

### [Monosaccharide]

The monosaccharide is a fundamental substance that cannot be broken down into simpler molecules by hydrolysis of sugars, and is a compound serving as constituent units of oligosaccharides and polysaccharides. The monosaccharide is generally represented by the general formula CₙH₂ₙO, of which those compounds having the numbers of carbon atoms (n) of 2, 3, 4, 5, 6, 7, 8, 9 and 10 are, respectively, called diose, triose, tetrose, pentose, hexsose, heptose, octose, nonose and decose.

As to the monosaccharides, compounds having an aldehyde group are classified as aldose, and compounds having a ketone group are classified as ketose. In the general formula CₙH₂ₙOₙ, compounds of n = 3 or over have an asymmetric carbon atom, and a number of steric isomers may exist depending the number of asymmetric carbon atoms, part of which are compounds known in nature. Compounds existing in nature include pentoses and hexoses in most cases. The monosaccharides used in the present embodiment are preferably aldoses, which are aldehydes of chain polyhydric alcohols of the type wherein n = 5 or over in the general formula CₙH₂ₙOₙ, in view of the fact that they exist abundantly in nature. Such monosaccharides include, for example, glucose, mannose, galactose, xylose and the like. Of these, glucose and galactose are preferred. If necessary, the monosaccharides may be used singly or in combination of two or more.

### [Sugar alcohol]

The sugar alcohol is a polyhydroxyalkane obtained by reducing an aldose or ketose. The sugar alcohol used in the embodiment is preferably a chain polyhydric alcohol. The sugar alcohol is represented by the general formula CₙH₂ₙ₊₁Oₙ, of which compounds having the numbers of carbon atoms (n) of 3, 4, 5, 6, 7, 8, 9 and 10 are, respectively, called tritol, tetritol, pentitol, hexitol, peptitol, octitol, nonitol and decitol.

The sugar alcohol includes a number of steric isomers depending on the number of asymmetric carbon atoms. In the present embodiment, the use of sugar alcohols of n = 3 to 6 in the general formula CₙH₂ₙ₊₁Oₙ is preferred. Specific examples of the sugar alcohol include sorbitol, mannitol, dulcitol, xylitol, erythritol, glycerine and the like. The sugar alcohols may be used singly or in combination of two or more, if necessary.

### [Oligosaccharides]

Oligosaccharides (oligo sugars) are compounds having such a structure that two to about 10 monosaccharides are linked through glycosidic bonds. The oligosaccharides are classified into disaccharide, trisacchairde, tetrasacchairde, pentasaccharide and the like. Specific examples of the oligosaccharide include sucrose, lactose, trehalose, cellobiose, maltose, raffinose, stachyose and the like. Additionally, the compounds alcoholized at ends of these oligosaccharides (terminally alcoholized oligosaccharides) may also be used.

### [Polysaccharides]

The polysaccharides are the generic term of polymeric compounds (whose degree of polymerization is 10 or over) wherein monosaccharides are polyglycosylated. A compound making use of one type of constituent saccharide is called homopolysaccharide, and a compound using two or more types thereof is called a heteropolysaccharide (heteroglycan). The polysaccharides widely exist in animals, plants and microrganims in the form of storage polysaccharides (starches, etc.), structural polysaccharides (celluloses, etc.), functional polysaccharides (heparins, etc.). The natural polysaccharides are polymeric compounds having an aldohexose and an aldopentose as constituent units wherein the aldohexose and aldopentose units are linearly, branchedly or cyclically joined by glycosidic bonds. The aldohexose and aldopentose form a six-membered ring structure, called pyranose ring, by intramolecular hemiacetal linkage between the aldehyde at the position of C1 and the alcohol at the position of C5. The aldohexose and aldopentose in the natural polysaccharides mainly take this pyranose ring structure.

The aldohexose and aldopentose that are, respectively, constituent units of natural polysaccharides include, aside from neutral monosaccharides, sulfuric acid esters, phosphoric acid esters, other types of organic acid esters and methyl ethers of neutral monosaccharides, uronic acids whose first alcohol group is oxidized into a carboxyl group, hexosamines, in which the hydroxyl group at the position of C2 of an aldohexose is substituted with an amino group, and derivatives thereof including N-acetylhexosamine, and 3,6-dideoxy-aldohexoses wherein an ether is formed between the hydroxyl groups at the positions of C3 and C6. The natural polysaccharides are widely distributed in animals and plants. In plants, they exist as cell wall constituents and constituents not taking part in the cell wall constituents of higher plants and seaweeds, and also exist in microorganisms as cell constituents. The constituents not taking part in the cell wall constituents of higher plants and seaweeds include mucilage contained in cell fluid and storage substances such as starch, etc. The natural polysaccharides in animals exist as storage substances such as glycogen, and as a constituent of mucus such as heparin, chondroitin sulfate or the like.

Depending on the type of constituent, the polysaccharides can be classified into neutral polysaccharide, acidic polysaccharide and basic polysaccharide. The neutral polysaccharide includes a mannan and a glucan as a homopolysaccharide. The heteropolysaccharides among the neutral polysaccharides include a compound consisting of hexose alone and contained in konjac, guaran and the like, and a compound consisting of pentose alone and contained in xylan, araboxylan and the like. On the other hand, tamarind and Actinidia rufa are known as plants containing hexose and pentose. The acidic polysaccharides include a substance containing uronic acid alone, Abelmoschus manihot and pectin both as a substance containing galacturonic acid and a neutral polysaccharide, and chamomile, Asparagus cochinchinensis and the like as a plants containing glucuronic acid and a neutral polysaccharide. Besides, mention may be further made of acidic polysaccharides containing sulfuric acid esters, phosphoric acid esters, organic acid esters, methyl ethers and 3,6-anhydrides. The basic polysaccharides include substances containing glucosamine and galactosamine as a constituent monosaccharide. The polysaccharides used in the present embodiment also include, aside from these natural polysaccharides, those compounds, which are obtained by hydrolyzing these polysaccharides by use of a catalyst made of an organic acid, an inorganic acid or a hydrolase for these polysaccharides in a solid phase, a liquid phase or a solid-liquid mixed phase, if necessary, by application of heat, and compounds obtained by subjecting natural polysaccharides or the compounds hydrolyzed above to a further processing treatment.

The further processing treatment for the natural polysaccharides or hydrolyzed products thereof includes, for example, the following methods.

Etherification treatment: including, for example an esterification treatment with an inorganic acid or an organic acid, ally esterification, methyl esterification, carboxymethyl esterification or the like.

Cationization treatment: including, for example, a cationization treatment wherein a polysaccharide or its hydrolyzed product is reacted with 2-diethylaminoethyl chloride or 2,3-epoxypropyltrimethylammonium chloride.

Crosslinking treatment: including, for example, a crosslinking method using formaldehyde, epichlorohydrin, phosphoric acid, acrolein or the like.

Graft polymerization treatment: including, for example, a method of graft-polymerizing a variety of monomers to polysaccharides or hydrolyzed products thereof. Examples of the monomer include vinyl acetate, vinyl propionate, t-butyl vinyl ether, (meth)acrylamide, (meth)acrylic acid, a (meth)acrylic acid alkyl ester, a (meth)acrylic acid hydroxyalkyl ester, a (meth)acrylic acid ethoxyalkyl ester, a (meth)acrylic acid methoxypolyethylene glycol ester, a (meth)acrylic acid 2-hydroxy-3-chloropropyl ester, a (meth)acrylic acid dimethylaminoethyl ester, a methacrylic acid glycidyl ester, acrylonitrile, styrene, maleic anhydride, itaconic acid and the like.

Of these natural polysaccharides and hydrolyzed products thereof, and the further treated products thereof, compounds soluble in water are preferred. Homopolysaccharides whose constituent monosaccharide is glucose are more preferred among the natural polysaccharides and hydrolyzed products thereof, and the further treated products thereof. The homopolysaccharides of glucose include, for example, starches, celluloses, dextran, pullulan, water-soluble chitins, chitosans and the like.

In the present embodiment, sugar alcohols of natural polysaccharides and hydrolyzed products thereof, and the further treated product thereof may be used instead thereof. The sugar alcohols of natural polysaccharides and hydrolyzed products thereof, and the further treated product thereof used herein mean compounds wherein the carbonyl group at the position of C1 at the reductive end thereof is reduced into an alcohol. Besides, sugars, such as cyclodextrin, wherein the molecular chains of a sugar are linked to form rings may also be used in the embodiment. The polysaccharides used in the embodiment may be used singly or in combination of two or more, if necessary.

### [Starches]

Although starches are included in the category of polysaccharides, the starches used in the present embodiment are now described in more detail.

The starches usable in the embodiment include raw starches (unmodified starches) such as wheat starch, corn starch, waxy maize starch, potato starch, tapioca starch, rice starch, sweet potato starch, sago starch and the like, and a variety of processed starches. Examples of the processed starch include physically modified starches such as pregelatinized starch, isolated and purified amylose, isolated and purified amylopectin, heat-moisture treated starch and the like, enzyme-modified starches such as hydrolyzed dextrin, enzyme-degraded starch, amylose and the like, chemically degraded starches such as acid-treated starch, hypochlorite-oxidized starch, dialdehyde starch and the like, chemically modified starches such as esterified starches (including acetic acid-esterified starch, succinic acid-esterified starch, nitric acid-esterified starch, phosphoric acid-esterified starch, urea/phosphoric acid-esterified starch, xanthogenic acid-esterified starch, acetoacetic acid-esterified starch and the like), etherified starches (including allyl etherified starch, methyl etherified starch, carboxymethyl etherified starch, hydroxyethyl etherified starch, hydroxypropyl etherified starch and the like), cationized starches (including a reaction product of starch and 2-diethylaminoethyl chloride, a reaction product of starch and 2,3-epoxypropyltrimethylammonium chloride, and the like), crosslinked starches (including formaldehyde-crosslinked starch, epichlorohydrin-crosslinked starch, phosphoric acid-crosslinked starch, acrolein-crosslinked starch and the like), and grafted starches obtained by graft polymerization of monomers on a variety of starches [wherein examples of the monomer include vinyl acetate, vinyl propionate, t-butyl vinyl ether, (meth)acrylamide, (meth)acrylic acid, (meth)acrylic alkyl esters, (meth)acrylic acid hydroxyalkyl esters, (meth)acrylic acid ethoxyalkyl esters, (meth)acrylic acid methoxypolyethylene glycol esters, (meth)acrylic acid 2-hydroxy-3-chloropropyl esters, (meth)acrylic acid dimethylaminoethyl esters, methacrylic acid glycidyl esters, acrylonitrile, styrene, maleic anhydride, itaconic acid and the like]. Of these starches, processed starches soluble in water are preferred. The starches may be hydrous ones. These starches may be used singly or in combination of two or more, if necessary.

### [Hypophosphite]

As a hypophosphite, mention is made of magnesium hypophosphite, potassium hypophosphite, sodium hypophosphite, calcium hypophosphite and the like. Among them, sodium hypophosphite and calcium hypophosphite are preferred, of which sodium hypophosphite is more preferred.

The hypophosphite is preferably contained at 1 mass% to 15 mass%, more preferably at 2 mass% to 10 mass%, per a total solid content (100 mass%) of the mixture comprised of an acrylic acid polymer made of poly(meth)acrylic acid or a partially neutralized product thereof wherein the degree of neutralization of poly(meth)acrylic acid polymer with zinc is not larger than 25 mol%, a sugar or starch, and a hypophosphite.

If the content of the hypophosphite relative to the total solid content of the mixture is less than 1 mass%, a prolonged thermal treatment time is necessary in the production process. On the other hand, the content of the hypophosphite relative to the total solid content of the mixture exceeds 15 mass%, little effect on the esterification reaction resulting from the increase in content of the hypophosphite cannot be expected, thereby impairing waterproofing properties.

When the content of the hypophosphite relative to the total solid content of the mixture ranges from 2 mass% to 10 mass%, it well acts as a catalyst for the esterification reaction, and a remaining hypophosphite does not adversely influence waterproofing properties and barrier properties.

In the gas barrier multilayer film 1 of the present embodiment, the formulation ratio between an acrylic acid polymer made of poly(meth)acrylic acid or a partially neutralized of poly(meth)acrylic acid whose degree of neutralization with zinc is not larger than 25 mol% and a sugar or starch is preferably 95/5 to 50/50, more preferably 95/5 to 60/40 and much more preferably 95/5 to 70/30, each based on " by mass".

If the formulation ratio between the acrylic acid polymer and the sugar or starch is less than 50/50 in terms of ratio by mass (i.e. if the formulation ratio of the acrylic acid polymer to the sugar or starch is less 50% by mass), waterproofing properties are impaired. On the other hand, if the formulation ratio by mass of the acrylic acid polymer to the sugar or starch exceeds 95/5 by mass (i.e. if the formulation ratio of the acrylic acid polymer to the sugar or starch exceeds 95% by mass), the amount of the hydroxyl group contributing to the esterification reaction becomes insufficient and thus, satisfactory barrier properties cannot be obtained.

When the formulation ratio between the acrylic acid polymer and the sugar or starch is changed from "95/5 to 50/50" through "95/5 to 60/40" to "95/5 to 70/30", better barrier properties are ensured due to the better balance obtained with respect to the ratio between the functional group of the acrylic acid polymer and the functional group of the sugar or starch, both contributing to the esterification reaction.

The gas barrier multilayer film 1 related to the present embodiment may further contain a variety of additives.

The additives include a silane coupling agent, a plasticizer, a resin, a dispersant, a surfactant, a softener, a stabilizer, an antiblocking agent, a film-forming agent, an adhesive, an oxygen absorbing agent and the like.

The amount of the additives is preferably 70/30 to 99.9/0.1, more preferably 80/20 to 98/2, in terms of the ratio between the mass of the acrylic acid polymer made of poly(meth)acrylic acid or a partially neutralized product of poly(meth)acrylic acid whose degree of neutralization with zinc is 25 mol% or below and the mass of the additives.

If the ratio between the mass of the acrylic acid polymer made of poly(meth)acrylic acid or a partially neutralized product of poly(meth)acrylic acid whose degree of neutralization with zinc is 25 mol% or below and the mass of the additives is within a range of "70/30 to 99.9/0.1", the additives show a satisfactory performance, and such additives do not adversely influence the barrier properties, a maltreatment resistance and waterproofing properties.

Moreover, if the ratio between the mass of the acrylic acid polymer made of poly(meth) acrylic acid or a partially neutralized product of poly(meth)acrylic acid whose degree of neutralization with zinc is 25 mol% or below and the mass of the additives is within a range of "80/20 to 98/2", the additives show a better performance and do not adversely influence the barrier properties, a maltreatment resistance and waterproofing properties.

The solvent used in the coating solution comprised of an acrylic acid polymer made of poly(meth) acrylic acid or a partially neutralized product of poly(meth)acrylic acid whose degree of neutralization with zinc is 25 mol% or below is preferably water or a mixed solvent of water and an organic solvent. More preferably, a mixed solvent of water and a lower alcohol having 1 to 5 carbon atoms is used. It will be noted that the mixed solvent used is one, which contains 20 mass% to 95 mass% of water and 80 mass% to 5 mass% of an organic solvent (provided that the total of water and the organic solvent is 100 mass%).

The gas barrier multilayer film 1 of the embodiment may be further stacked with other type of substrate for the purposes of imparting strength, sealability and easy-to-open properties after sealing, designability and light blocking properties thereto.

Other type of substrate may be appropriately chosen depending on the purpose and usually include plastic films, papers and the like.

The plastic films and papers may be used singly or in combination of two or more as laminated. Alternatively, a plastic film and paper may be used in lamination.

The lamination method of other type of substrate on the gas barrier multilayer film 1 includes, for example, one wherein lamination is carried out according to a lamination technique using an adhesive. Specific lamination methods include dry lamination, wet lamination, extrusion lamination and the like.

It will be noted that the printing or vacuum deposition may be performed on other type of substrate from the standpoint of imparting designability, light blocking properties and moisture proofness.

According to this embodiment, gas barrier properties are not lowered by moisture absorption and the gas barrier layer 4 itself is excellent in maltreatment resistance, so that gas barrier properties are unlikely to undergo degradation after having subjected to flexing, stretching and the like. Thus, there can be obtained the gas barrier multilayer film 1 having excellent gas barrier properties.

### [Method of fabricating gas barrier multilayer film 1]

A method for fabricating a gas barrier multilayer film according to a second embodiment of the invention includes the step of forming a gas barrier layer 4 on a layer 3 formed on at least one surface of a film substrate 2 and made of an inorganic compound, wherein the gas barrier layer 4 is formed by coating, onto the layer 3 made of the inorganic compound, a coating solution containing a mixture of an acrylic acid polymer made of poly(meth)acrylic acid or a partially neutralized product of pol(meth)acrylic acid whose degree of neutralization with zinc is not larger than 25 mol%, a sugar or starch, and a hypophosphite, and subjecting to thermal treatment at a temperature of from 150°C to 250°C, inclusive, for 300 seconds or below.

The coating (application) method of the coating solution for forming the gas barrier layer 4 is not specifically limited and includes, for example, a casting method, a dipping method, a roll coating method, a gravure coating method, a screen printing method, a reverse coating method, a spray coating method, a kit coating method, a die coating method, a metalling bar coating method, a coating method combined with a chamber doctor, a curtain coating method or the like.

The coating and drying are successively carried and if two or more gas barrier layers are stacked, the coating may be effected continuously, or discontinuously through a take-up step or an aging step. It will be noted that where two or more gas barrier layers are stacked, one layer is provided, for example, as the gas barrier layer 4 and another layer may be provided as an arbitrary different layer.

The method of drying the coating solution after the coating is not specifically limited and includes, for example, a hot air drying method, a hot roll contact method, an infrared heating method, a microwave heating method or the like. These methods may be used singly or in combination.

The drying temperature is not specifically limited and is preferably 50°C to 160°C in the case where the solvent used is, for example, water or a mixed solvent of water and an organic solvent as set out above. The pressure used for the drying is preferably a normal pressure or a reduced pressure, of which a normal pressure is more preferred in view of the simplicity of apparatus.

The thermal treatment temperature (T) is selected from a range of 150°C (423 K) to 250°C (523 K). However, in order to obtain a high-quality gas barrier film within a low thermal treatment temperature range, a much prolonged thermal treatment time is required, thus lowering productivity. Although a higher thermal treatment temperature enables high gas barrier properties to be obtained within a shorter thermal treatment time, too high a temperature may cause discoloration or decomposition. Thus, the thermal treatment temperature (T) is preferably from 170°C (443 K) to 230°C (503 K), more preferably from 180°C (453 K) to 210°C (483 K). The upper limit of the thermal treatment temperature should be within a range of not causing decomposition or melting of the film at a given thermal treatment temperature.

According to the present embodiment, there can be obtained the gas barrier multilayer film 1 having excellent gas barrier properties, in which gas barrier properties are not lowered by moisture absorption, and the gas barrier layer 4 itself is excellent in maltreatment resistance, so that gas barrier properties are unlikely to undergo degradation after having subjected to flexing, stretching and the like.

### Examples

The invention is more particularly described by way of examples and comparative examples, and the invention should not be construed as limited to the following examples.

### <Preparation of coating solution>

### [Preparatory Example 1]

Polyacrylic acid (commercial name: Aron A-10H with a number average molecular weight of 200,000 in the form of 25 mass% aqueous solution, manufactured by Toagosei Co., Ltd.) was dissolved in distilled water to prepare a polyacrylic acid (PAA) aqueous solution having a solid concentration of 10 mass%.

This PAA aqueous solution and a hydrogenated starch hydrolyzate (commercial name: P020 in the form of a 70 mass% aqueous solution, manufactured by Mitsubishi Shoji Foodtech Co., Ltd.) were mixed at a ratio by mass (solid content ratio) of 80/20 as indicated in Table 1.

Next, sodium hypophosphite was added to the mixed solution at 10 mass% relative to the total solid content.

Finally, the total solid concentration of the aqueous solution was set at 5 mass% to prepare coating solution (1).

### [Preparatory Example 2]

Zinc oxide was added to the PAA aqueous solution, which had a solid concentration of 10 mass% and was obtained in the same way as in Preparatory Example 1, in such a way that an amount of Zn was 10 mol% relative to the moles of the carboxyl group in the polyacrylic acid aqueous solution thereby preparing an aqueous solution of a product (PAAZn) of the polyacrylic acid partially neutralized with Zn (coating solution (2)).

### [Preparatory Examples 3 to 5]

The 10 mol% PAAZn aqueous solution obtained in the same manner as in Preparatory Example 2 and a hydrogenated starch hydrolyzate (commercial name: P020 in the form of a 70 mass% aqueous solution, manufactured by Mitsubishi Shoji Foodtech Co., Ltd.) were mixed at different ratios by mass (solid content ratios) of 90/10 to 70/30 as indicated in Table 1.

Next, sodium hypophosphite was added to the mixed solution in an amount of 10 mass% relative to the total solid content.

Finally, coating solutions (3) to (5) were prepared in such a way that the total solid concentrations of the aqueous solutions were 5 mass%, respectively.

### [Preparatory Examples 6 to 8]

Zinc oxide was added to the PAA aqueous solution obtained in the same way as in Preparatory Example 1 and having a solid concentration of 10 mass% in such a way that an amount of Zn was 20 mol% relative to the moles of the carboxyl group in the polyacrylic acid aqueous solution to prepare a PAAZn aqueous solution.

This 20 mol% PAAZn aqueous solution and a hydrogenated starch hydrolyzate (commercial name: P020 in the form of a 70 mass% aqueous solution, manufactured by Mitsubishi Shoji Foodtech Co., Ltd.) were mixed at different ratios by mass (solid ratios) of 90/10 to 70/30 as indicated in Table 1.

Next, sodium hypophosphite was added to the respective mixed solutions at 10 mass% relative to the total solid content.

Finally, coating solutions (6) to (8) were prepared so that the total solid concentrations of the aqueous solutions were 5 mass%, respectively.

### [Preparatory Examples 9 to 12]

The 10 mol% PAAZ aqueous solution obtained in the same way as in Preparatory Example 2 and a hydrogenated starch hydrolyzate (commercial name: P020 in the form of a 70 mass% aqueous solution, manufactured by Mitsubishi Shoji Foodtech Co., Ltd.) were mixed at a ratio by mass (solid content ratio) of 80/20 as indicated in Table 1.

Next, sodium hypophosphite was added to the mixed solution at 1.5 mass% to 20 mass% relative to the total solid content of the aqueous solution.

Finally, coating solutions (9) to (12) were prepared so that the total solid concentrations of the aqueous solutions were 5 mass%, respectively.

### [Preparatory Example 13]

A soluble starch (manufactured by Alfa-Aesar Inc.) used as a starch was dissolved in distilled water to prepare a soluble starch aqueous solution having a solid concentration of 10 mass%.

In the same manner as in Preparatory Example 3 except that the hydrogenated starch hydrolyzate was replaced by the soluble starch aqueous solution, coating solution (13) was prepared so that a total solid concentration of the aqueous solution was 5 mass%.

It will be noted that in Preparatory Example 13, the mixed solution used was one wherein the 10 mol% PAAZn aqueous solution and the soluble starch aqueous solution were mixed at a ratio by mass (solid content ratio) of 80/20.

### [Preparatory Example 14]

Polyvinyl alcohol (commercial name: PVA 124, manufactured by Kuraray Co., Ltd.) was dissolved in distilled water to prepare a polyvinyl alcohol aqueous solution having a solid concentration of 5 mass%.

In the same manner as in Preparatory Example 3 except that the hydrogenated starch hydrolyzate was replaced by the polyvinyl alcohol, coating solution (14) was prepared so that a total solid concentration of the aqueous solution was 5 mass%.

It will be noted that in Preparatory Example 14, the mixed solution used was one wherein the 10 mol% PAAZn aqueous solution and the polyvinyl alcohol aqueous solution were mixed at a ratio by mass (solid content) of 80/20 as indicated in Table 1.

### [Preparatory Example 15]

In the same manner as in Preparatory Example 3 except that sodium hypophosphite was not added, coating solution (15) was prepared to have a solid concentration of 5 mass%.

It will be noted that in Preparatory Example 15, the mixed solution used was one wherein the 10 mol% PAAZn aqueous solution and the hydrogenated starch hydrolysate aqueous solution were mixed at a ratio by mass (solid content) of 80/20 as indicated in Table 1.

### <Fabrication of gas barrier multilayer film>

### [Example 1]

Metallic aluminum was evaporated on a biaxially stretched polyethylene terephthalate film (commercial name: Lumilar P60 with a thickness of 12 µm and with a corona-treated inner side, manufactured by Toray Corp.) by means of a vacuum deposition apparatus using an electron beam heating system, and an oxygen gas was introduced into vaporized aluminum, followed by vacuum deposition of the resulting aluminum oxide to form a 20 nm thick inorganic compound layer.

Next, the coating solution (1) was coated onto the inorganic compound layer by a bar coater and dried by a drying machine at 210°C for 1 minute to form an about 0.6 µm thick film thereby obtaining a gas barrier multilayer film.

### [Examples 2 to 10]

In the same manner as in Example 1, the coating solutions (3) to (8) and (10) to (12) were each coated onto the inorganic compound layer to obtain gas barrier multilayer films.

### [Examples 11, 12]

In the same manner as in Example 3, the coating solution (4) was coated onto the inorganic compound layer, followed by drying at thermal treatment temperatures (150°C, 250°C), indicated in Table 1, for 1 minute to obtain gas barrier multilayer films.

### [Example 13]

In the same manner as in Examples 1 to 7, the coating solution (13) was coated onto the inorganic compound layer to obtain a gas barrier multilayer film.

### [Comparative Example 1]

Metallic aluminum was evaporated on a biaxially stretched polyethylene terephthalate film (commercial name: Lumilar P60 with a thickness of 12 µm and with a corona-treated inner side, manufactured by Toray Corp.) by means of a vacuum deposition apparatus using an electron beam heating system, and an oxygen gas was introduced into vaporized aluminum, followed by vacuum deposition of the resulting aluminum oxide to form a 20 nm thick inorganic compound layer thereby obtaining a gas barrier multilayer film.

### [Comparative Example 2]

In the same manner as in Examples 1 to 11, the coating solution (14) was coated onto the inorganic compound layer to obtain a gas barrier multilayer film.

### [Comparative Example 3]

In the same manner as in Examples 1 to 11, the coating solution (15) was coated onto the inorganic compound layer to obtain a gas barrier multilayer film.

### [Comparative Example 4]

In the same manner as in Examples 1 to 11, the coating solution (2) was coated onto the inorganic compound layer to obtain a gas barrier multilayer film.

### [Comparative Example 5]

In the same manner as in Examples 1 to 11, the coating solution (9) was coated onto the inorganic compound layer to obtain a gas barrier multilayer film.

The gas barrier multilayer films obtained in Examples 1 to 13 and Comparative Examples 1 to 5 were successively attached to Ny (stretched nylon film) and CPP (polypropylene film) with an adhesive by use of Multicoater TM-MC, manufactured by HIRANO TECSEED Co., Ltd., to obtain laminate films each having a configuration of gas barrier multilayer film/adhesive/Ny/adhesive/CPP. The lamination surface was arranged in contact with the adhesive. It will be noted that the lamination surface means a surface of the gas barrier multilayer film on which the respective layers are laminated.

Moreover, the gas barrier multilayer films obtained in Examples 1 to 13 and Comparative Examples 1 to 5 were each attached to LLDPE (linear, low density polyethylene film) to obtain laminate films having a configuration of gas barrier multilayer film/adhesive/LLDPE.

The adhesive used was a two-component curing adhesive, Takelac A620 (main agent)/Takenate A65 (curing agent), manufactured by Mitsui Chemicals, Inc.

Ny used was a stretched nylon film, Emblem ONM (15 µm), manufactured by Unitika Ltd.

CPP used was a polypropylene film, Torayfan ZK93FM (60 µm), manufactured by Toray Advanced Film Co., Ltd.

LLDPE used was a linear low-density polyethylene film, TUX-TCS (60 µm), manufactured by Mitsui Chemicals Tohcello, Inc.

The resulting laminate films were, respectively, aged 40°C for 3 days after the attachment.

### [Evaluation]

### (1) Evaluation of flex resistance

The thus obtained laminate films (configuration: gas barrier multilayer film/adhesive/Ny/adhesive/CPP) were, respectively, cut into a 295 mm long × 210 mm wide piece.

The thus cut laminate film was attached to a fixed head of Gelbo Flex test, manufactured by Tester Sangyo Co., Ltd., in the form of a cylinder of 87.5 mm in diameter × 210 mm in length.

The laminate film was held at opposite ends thereof and twisted by 440 degrees under conditions of an initial grip distance of 175 mm and a stroke of 87.5 mm. The reciprocation movement of this operation was repeated 50 times at a speed of 40 times/minute. The laminate film piece was flexed in this way, followed by measurement of oxygen and water vapor permeation rates under the following conditions. The results of the evaluation are shown in Table 2.

### (2) Evaluation of resistance to stretching

The laminate films (configuration: gas barrier multilayer film/adhesive/LLDPE) were, respectively, cut into a 200 mm long × 150 mm wide piece.

The thus cut laminate film was stretched by 5% in a longitudinal direction at a speed of 100 µm/second by use of a tensilon tester, manufactured by Toyo Baldwin Corporation, and this state was kept for 1 minute, after which the film was returned to the original position at the same speed (100 µm/second).

This sample was subjected to measurement of oxygen and water vapor permeation rates under the following conditions.

The results of the evaluation were shown in Table 2.

### (3) Measurement of oxygen permeation rate

Using an oxygen permeation tester (OXTRAN 2/20, manufactured by Modern Control Inc.), the oxygen permeation rate of the respective laminate films was measured under conditions of a temperature of 30°C and a relative humidity of 70%. The measuring method conformed to JIS K-7126 ["B method" (equal pressure method)] and ASTM D3985-81, and a measured value was expressed in units of cm³ (STP)/(m²·day·MPa).

The results of the evaluation are shown in Table 2.

It will be noted that as to the results of the test of "prior to maltreatment" in Table 2, there are shown the results of measurement of the oxygen permeation rate of the gas barrier multilayer films alone (i.e. gas barrier multilayer films not subjected to further lamination). As to the results of the test "after maltreatment", there are shown the results of measurement of the oxygen permeation rates of the laminate films having subjected to the above "(1) Evaluation of flex resistance" and the laminate films having subjected to the above "(2) Evaluation of resistance to stretching".

### (4) Measurement of hydrogen permeation rate

Using a water vapor permeation tester (PERMATRAN 3/31, manufactured by Modern Control Inc.), the hydrogen permeation rate of the respective laminate films was measured under conditions of a temperature of 40°C and a relative humidity of 90%. The measuring method conformed to JIS K-7129 and ASTM F1249-90, and a measured value was expressed in units of g (STP)/(m²·day).

The results of the evaluation are shown in Table 2.

It will be noted that the results of the test "prior to maltreatment" in Table 2 mean the results of measurement of the water vapor permeation rate of the gas barrier multilayer films alone (i.e. gas barrier multilayer films not subjected to further lamination). As to the results of the test "after maltreatment" in Table 2, there are, respectively, shown the results of measurement of the water vapor permeation rates of the laminate films having subjected to the above "(1) Evaluation of flex resistance" and the laminate films having subjected to "(2) Evaluation of resistance to stretching".

**[Table 1]**

| | Coating solution | Formulation ratio | | | | | Thermal treatment conditions |
|---|---|---|---|---|---|---|---|
| | | PAA | | Compound having hydroxyl group | | Sodium hypophosphite | |
| | | Degree of neutralization with Zn (mol%) | Amount (wt%) | Kind | Amount (wt%) | (Ratio to the total of PAA and a compound having a hydroxylgroup) Amount (wt%) | |
| Example 1 | (1) | 0 | 80 | Hydrogenated starch hydrolysate | 20 | 10 | 210°C, 1min. |
| Example 2 | (3) | 10 | 90 | Hydrogenated starch hydrolysate | 10 | 10 | 210°C, lmin. |
| Example 3 | (4) | 10 | 80 | Hydrogenated starch hydrolysate | 20 | 10 | 210°C, 1min. |
| Example 4 | (5) | 10 | 70 | Hydrogenated starch hydrolysate | 30 | 10 | 210°C, 1min. |
| Example 5 | (6) | 20 | 90 | Hydrogenated starch hydrolysate | 10 | 10 | 210°C, 1min. |
| Example 6 | (7) | 20 | 80 | Hydrogenated starch hydrolysate | 20 | 10 | 210°C, 1min. |
| Example 7 | (8) | 20 | 70 | Hydrogenated starch hydrolysate | 30 | 10 | 210°C, 1min. |
| Example 8 | (10) | 10 | 80 | Hydrogenated starch hydrolysate | 20 | 1.5 | 210°C, 1min. |
| Example 9 | (11) | 10 | 80 | Hydrogenated starch hydrolysate | 20 | 5 | 210°C, 1min. |
| Example 10 | (12) | 10 | 80 | Hydrogenated starch hydrolysate | 20 | 15 | 210°C, 1min. |
| Example 11 | (4) | 10 | 80 | Hydrogenated starch hydrolysate | 20 | 10 | 150°C, 1min. |
| Example 12 | (4) | 10 | 80 | Hydrogenated starch hydrolysate | 20 | 10 | 250°C, 1min. |
| Example 13 | (13) | 10 | 80 | Soluble starch | 20 | 10 | 210°C, 1min. |
| Comparative Example 1 | - | - | - | - | - | - | - |
| Comparative Example 2 | (14) | 10 | 80 | Polyvinyl alcohol | 20 | 10 | 210°C, 1min. |
| Comparative Example 3 | (15) | 10 | 80 | Hydrogenated starch hydrolysate | 20 | - | 210°C, 1min. |
| Comparative Example 4 | (2) | 10 | 100 | - | 0 | 10 | 210°C, 1min. |
| Comparative Example 5 | (9) | 10 | 80 | Hydrogenated starch hydrolysate | 20 | 20 | 210°C, 1min. |

**[Table 2]**

| | Coating solution | Oxygen permeation rate (cm³/m².day.MPa) | | | Water vapor permeation rate (g/cm².day) | | |
|---|---|---|---|---|---|---|---|
| | | Prior to Maltreatment | After maltreatment | | Prior to Maltreatment | After maltreatment | |
| | | | Flex | Stretch | | Flex | Stretch |
| Example 1 | (1) | 0.3 | 5 | 2 | 0.3 | 1 | 2 |
| Example 2 | (3) | 0.2 | 5 | 2 | 0.1 | 1 | 2 |
| Example 3 | (4) | 0.2 | 5 | 2 | 0.1 | 1 | 2 |
| Example 4 | (5) | 0.2 | 5 | 2 | 0.3 | 1 | 2 |
| Example 5 | (6) | 0.2 | 5 | 2 | 0.1 | 1 | 2 |
| Example 6 | (7) | 0.2 | 5 | 2 | 0.1 | 1 | 2 |
| Example 7 | (8) | 0.2 | 5 | 2 | 0.3 | 1 | 2 |
| Example 8 | (10) | 0.3 | 5 | 2 | 0.3 | 1 | 2 |
| Example 9 | (11) | 0.2 | 5 | 2 | 0.2 | 1 | 2 |
| Example 10 | (12) | 0.2 | 5 | 2 | 0.2 | 1 | 2 |
| Example 11 | (4) | 5 | 10 | 2 | 0.5 | 2 | 2 |
| Example 12 | (4) | 0.2 | 5 | 2 | 0.2 | 1 | 2 |
| Example 13 | (13) | 0.1 | 4 | 2 | 0.1 | 1 | 2 |
| Comparative Example 1 | - | 15 | 50 | 400 | 2.5 | 8 | 8 |
| Comparative Example 2 | (14) | 5 | 10 | 10 | 0.5 | 1 | 2 |
| Comparative Example 3 | (15) | 3 | 10 | 5 | 0.5 | 1 | 2 |
| Comparative Example 4 | (2) | 5 | 10 | 10 | 0.6 | 1 | 2 |
| Comparative Example 5 | (9) | 7 | 10 | 10 | 2 | 3 | 5 |

From the results of Table 2, it will be seen that when using the gas barrier multilayer films of Examples 1 to 13, there can be obtained the laminate films that are excellent in maltreatment resistance, and are less likely to be degraded in gas barrier properties when subjected to flexing and stretching, and have excellent gas barrier properties.

### Industrial Applicability

The gas barrier multilayer film of the present invention has high barrier properties and are not degraded in gas barrier properties even after having subjected to maltreatments (hard use) such as of flexing or stretching. When the gas barrier multilayer film of the invention is used and subjected to post-processing such as of a printing process, dry lamination, melt extrusion lamination, thermocompression lamination or the like, there can be provided packaging materials that are employed in the packaging field of vacuum heat insulating materials, life-related materials (foods, medical goods) and have a wide range of applications.

### Reference Signs List

- 1: Gas barrier multilayer film
- 2: Film substrate
- 3: Layer made of an inorganic compound
- 4: Gas barrier layer

## Claims

1. A gas barrier multilayer film comprising:
a film substrate;
a layer formed on at least one surface of the film substrate and made of an inorganic compound; and
a gas barrier layer formed on the layer made of the inorganic compound and formed of a mixture, which contains an acrylic acid polymer made of poly(meth)acrylic acid or a partially neutralized product thereof wherein a degree of neutralization of the poly(meth)acrylic acid with zinc is not larger than 25 mol%, a sugar or starch, and a hypophosphite wherein the hypophosphite is present at 1 mass% to 15 mass% of a total solid content of the mixture.

2. The gas barrier multilayer film according to Claim 1, wherein the layer made of the inorganic compound is formed by a vacuum deposition process and can be made of at least one member selected from the group consisting of aluminum, aluminum oxide, magnesium oxide and silicon oxide.

3. A method for manufacturing a gas barrier multilayer film comprising
forming a gas barrier layer on a layer which is formed on at least one surface of a film substrate and made of an inorganic compound, wherein
when the gas barrier layer is formed, a coating solution, which is comprised of a mixture of an acrylic acid polymer made of poly(meth)acrylic acid or a partially neutralized product thereof wherein a degree of neutralization of the poly(meth)acrylic acid with zinc is not larger than 25 mol%, a sugar or starch, and a hypophosphite, is coated and thermally treated at a temperature of from 150°C to 250°C, inclusive, for 300 seconds or below.
